# EUROPEAN PATENT APPLICATION

(11) **EP 4 622 433 A1**
(43) Date of publication of application: **24.09.2025**
(21) Application number: 25163918.3
(22) Date of filing: 14.03.2025
(51) Int. Cl.: H10K 59/80, H10K 71/00

(54) **DISPLAY PANEL AND DISPLAY PANEL ASSEMBLY**

(30) Priority: 18.03.2024 KR 20240037020
(71) Applicant: Samsung Display Co., Ltd., Gyeonggi-Do (KR)
(72) Inventor: CHA, Jonghwan, Yongin-si (KR); KANG, Ki Nyeng, Yongin-si (KR)
(74) Representative: Marks & Clerk LLP

(57) **Abstract**

A display panel in which a display area and a non-display area are defined includes a lower substrate, an upper substrate, and a filler disposed between the lower substrate and the upper substrate. The non-display area includes a first edge area extending in a first direction, a second edge area spaced apart from the first edge area in a second direction perpendicular to the first direction and extending in the first direction, a third edge area connecting the first edge area and the second edge area, and a fourth edge area spaced apart from the third edge area in the first direction. A seal is disposed between the upper and lower substrates in at least one edge area among the first to fourth edge areas, and the filler extends from the display area and is disposed in at least one edge area among the first to fourth edge areas.

## Description

### BACKGROUND

### 1. Field

The disclosure relates to a display panel and a display panel assembly used to manufacture a plurality of unit display panels.

### 2. Description of Related Art

Electronic devices, such as televisions, mobile phones, tablet computers, navigation devices, and game devices, include a display panel displaying images. The display panel includes a lower substrate including a light-emitting element and an upper substrate.

A display panel assembly used to manufacture a plurality of unit display panels includes a lower mother substrate, an upper mother substrate, and a seal and a filler to combine the lower mother substrate with the upper mother substrate.

### SUMMARY

The disclosure provides a display panel with improved reliability.

The disclosure provides a display panel assembly with improved process efficiency.

An embodiment of the inventive concept provides a display panel in which a display area and a non-display area surrounding the display area are defined. The display panel includes a lower substrate including a light-emitting element layer, an upper substrate disposed on the lower substrate, and a filler disposed between the lower substrate and the upper substrate to overlap the display area. The non-display area includes a first edge area extending in a first direction, a second edge area spaced apart from the first edge area in a second direction perpendicular to the first direction and extending in the first direction, a third edge area extending in the second direction and connecting an end of the first edge area and an end of the second edge area, and a fourth edge area spaced apart from the third edge area in the first direction and extending in the second direction. A seal is disposed between the upper substrate and the lower substrate in at least one edge area among the first to fourth edge areas, and the filler extends from the display area and is disposed in at least one edge area among the first to fourth edge areas.

In an embodiment, the seal may be directly disposed between the upper substrate and the lower substrate to combine the upper substrate and the lower substrate.

In an embodiment, the seal may be disposed in one edge area among the first to fourth edge areas, and the filler may extend and be disposed in the remaining three edge areas in which the seal is not disposed among the first to fourth edge areas.

In an embodiment, the seal may be disposed in two edge areas among the first to fourth edge areas, and the filler may extend and be disposed in the remaining two edge areas in which the seal is not disposed among the first to fourth edge areas.

In an embodiment, the seal may be disposed in three edge areas among the first to fourth edge areas, and the filler may extend and be disposed in the remaining one edge area in which the seal is not disposed among the first to fourth edge areas.

In an embodiment, the non-display area may further include a pad area spaced apart from the display area and next to the first edge area.

In an embodiment, the lower substrate may further include an encapsulation layer disposed on the light-emitting element layer, the encapsulation layer may include a first inorganic encapsulation layer disposed on the light-emitting element layer, an organic encapsulation layer disposed on the first inorganic encapsulation layer, and a second inorganic encapsulation layer disposed on the organic encapsulation layer, and the seal may overlap the first inorganic encapsulation layer and the second inorganic encapsulation layer and may not overlap the organic encapsulation layer.

An embodiment of the inventive concept provides a display panel assembly including a plurality of unit display panels each in which a display area and a non-display area surrounding the display area are defined. The display panel assembly includes a lower mother substrate including a light-emitting element, an upper mother substrate disposed on the lower mother substrate, and a filler disposed between the lower mother substrate and the upper mother substrate to overlap the display area. The non-display area includes a first edge area extending in a first direction, a second edge area spaced apart from the first edge area in a second direction perpendicular to the first direction and extending in the first direction, a third edge area extending in the second direction and connecting an end of the first edge area and an end of the second edge area, and a fourth edge area spaced apart from the third edge area in the first direction and extending in the second direction. A seal is disposed between the upper mother substrate and the lower mother substrate in at least one edge area among the first to fourth edge areas, and the filler extends from the display area and is disposed in at least one edge area among the first to fourth edge areas.

In an embodiment, a cutting area surrounding each of the plurality of unit display panels may be defined in the display panel assembly.

In an embodiment, the seal may be directly disposed between the upper mother substrate and the lower mother substrate to combine the upper mother substrate and the lower mother substrate.

In an embodiment, the non-display area further may include a pad area spaced apart from the display area and next to the first edge area.

In an embodiment, the plurality of unit display panels may include a plurality of first unit display panels and a plurality of second unit display panels spaced apart from the plurality of first unit display panels and alternately arranged with the plurality of first unit display panels in the first direction, the seal may be disposed in two edge areas among the first to fourth edge areas defined in the plurality of first unit display panels, and the filler may extend and be disposed in the remaining two edge areas in which the seal is not disposed among the first to fourth edge areas defined in the plurality of first unit display panels.

In an embodiment, the seal may be disposed in one edge area among the first to fourth edge areas defined in the plurality of second unit display panels, and the filler may extend and be disposed in the remaining three edge areas in which the seal is not disposed among the first to fourth edge areas defined in the plurality of second unit display panels.

In an embodiment, the seal may be disposed in the second and third edge areas of the plurality of first unit display panels, the filler may extend and be disposed in the first and fourth edge areas of the plurality of first unit display panels, the seal may be disposed in the second edge area of the plurality of second unit display panels, and the filler may extend and be disposed in the first, third, and fourth edge areas of the plurality of second unit display panels.

In an embodiment, the seal may be disposed in the first and third edge areas of the plurality of first unit display panels, the filler may extend and be disposed in the second and fourth edge areas of the plurality of first unit display panels, the seal may be disposed in the first edge area of the plurality of second unit display panels, and the filler may extend and be disposed in the second, third, and fourth edge areas of the plurality of second unit display panels.

In an embodiment, the seal may be disposed in two edge areas among the first to fourth edge areas defined in the plurality of second unit display panels, and the filler may extend and be disposed in the remaining two edge areas in which the seal is not disposed among the first to fourth edge areas defined in the plurality of second unit display panels.

In an embodiment, the seal may be disposed in the first and second edge areas of both the plurality of first and second unit display panels, and the filler may extend and be disposed in the third and fourth edge areas of both the plurality of first and second unit display panels.

In an embodiment, the seal may be disposed in the first and third edge areas of both the plurality of first and second unit display panels, and the filler may extend and be disposed in the second and fourth edge areas of both the plurality of first and second unit display panels.

In an embodiment, the seal may be disposed in three edge areas among the first to fourth edge areas defined in the plurality of second unit display panels, and the filler may extend and be disposed in the remaining one edge area in which the seal is not disposed among the first to fourth edge areas defined in the plurality of second unit display panels.

In an embodiment, the seal may be disposed in the first and second edge areas defined in the plurality of first unit display panels, the filler may extend and be disposed in the third and fourth edge areas defined in the plurality of first unit display panels, the seal may be disposed in the first, second, and fourth edge areas defined in the plurality of second unit display panels, and the filler may extend and be disposed in the third edge area defined in the plurality of second unit display panels.

At least some of the above and other features of the invention are set out in the claims.

According to the above, the seal is used to combine the upper substrate with the lower substrate of the display panel, and the seal's underfilling, overfilling, and/or bursting defects are reduced. Thus, the reliability of the display panel is improved.

According to the above, the use of the seal to combine the upper mother substrate with the lower mother substrate is reduced in the display panel assembly, and thus, defects caused by the unevenness and overlapping of the seal are reduced. Accordingly, the process efficiency of the display panel assembly is improved.

### BRIEF DESCRIPTION OF THE DRAWINGS

The above and other advantages of the disclosure will become readily apparent by reference to the following detailed description when considered in conjunction with the accompanying drawings, in which:
FIG. 1 is an assembled perspective view of an embodiment of an electronic device according to the disclosure;
FIG. 2 is an exploded perspective view of an embodiment of an electronic device according to the disclosure;
FIGS. 3A and 3B are cross-sectional views of electronic devices taken along line I-I' of FIG. 2;
FIG. 4 is a plan view of an embodiment of a display panel according to the disclosure;
FIG. 5 is a cross-sectional view of an embodiment of a portion of a display area according to the disclosure;
FIGS. 6 to 7 are cross-sectional views of an embodiment of portions of display devices in embodiments of the disclosure; and
FIGS. 8A to 8E are plan views of an embodiment of a display panel assembly according to the disclosure.

### DETAILED DESCRIPTION

The disclosure may be variously modified and realized in many different forms, and thus illustrative embodiments will be exemplified in the drawings and described in detail hereinbelow. However, the disclosure should not be limited to the specific disclosed forms, and be construed to include all modifications, equivalents, or replacements included in the scope of the disclosure.

As used herein, the singular forms, "a", "an" and "the" are intended to include the plural forms as well, unless the context clearly indicates otherwise.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

In the disclosure, it will be understood that when an element (or area, layer, or portion) is referred to as being "on", "connected to" or "coupled to" another element or layer, it may be directly on, connected or coupled to the other element or layer or intervening elements or layers may be present.

Spatially relative terms, such as "below", "lower", "above", "upper" and the like, may be used herein for ease of description to describe one element or feature's relationship to other elements or features as shown in the drawing figures.

In the disclosure, the term "on" may mean that a portion of an element is disposed at a lower portion as well as an upper portion of another element.

In the disclosure, when an element is referred to as being "directly connected" to another element, there are no intervening elements present between a layer, film, region, or substrate and another layer, film, region, or substrate. For example, the term "directly connected" may mean that two layers or two members are disposed without employing additional adhesive therebetween.

As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element and vice versa without departing from the teachings of the disclosure.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Like numerals refer to like elements throughout. In the drawings, the thickness, ratio, and dimension of components are exaggerated for effective description of the technical content.

Hereinafter, a display panel and a display panel assembly of the disclosure will be described with reference to accompanying drawings.

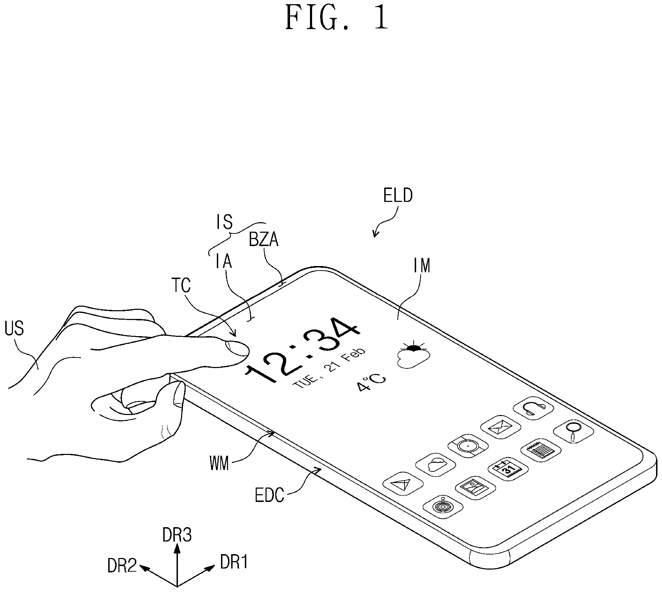

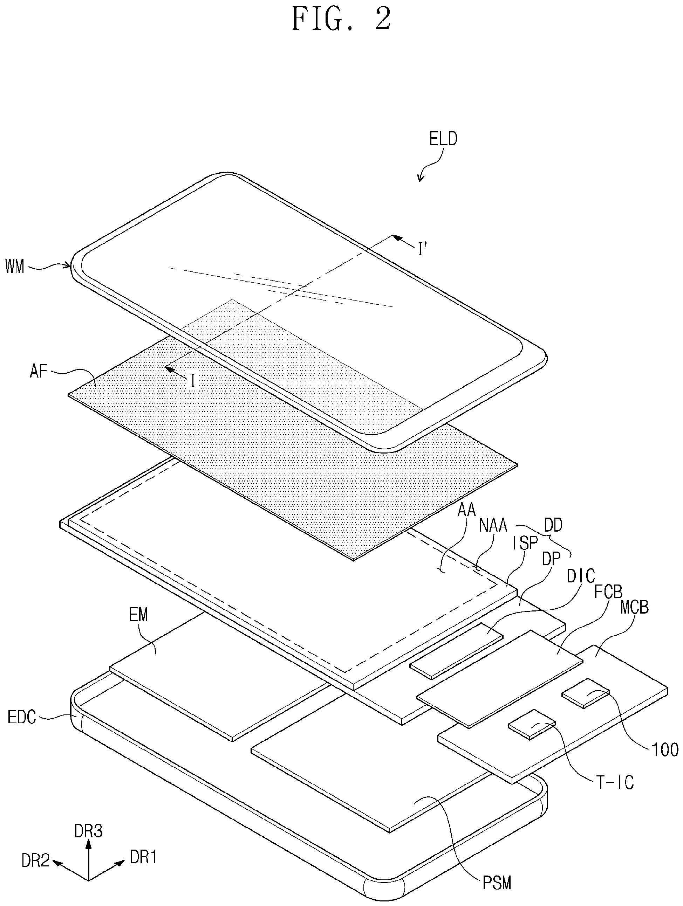

FIG. 1 is an assembled perspective view of an embodiment of an electronic device ELD according to the disclosure. FIG. 2 is an exploded perspective view of an embodiment of the electronic device ELD according to the disclosure.

Referring to FIG. 1, the electronic device ELD may be activated in response to electrical signals and may display images. In an embodiment, the electronic device ELD may be applied to a large-sized display device, such as a television set, an outdoor billboard, etc., and a small and medium-sized display device, such as a monitor, a mobile phone, a tablet computer, a navigation unit, a game unit, etc. However, these are merely illustrative embodiments, and the electronic device ELD may be applied to other display devices as long as they do not depart from the concept of the disclosure.

The electronic device ELD may be rigid or flexible. The term "flexible" used herein refers to the property of being able to be bent. In an embodiment, the electronic device ELD that is flexible may be a curved device, a rollable device, or a foldable device, for example.

In the illustrated embodiment, a third direction DR3 may be substantially perpendicular to a plane defined by a first direction DR1 and a second direction DR2. Front (or upper) and rear (or lower) surfaces of each member of the electronic device ELD may be opposite to each other in the third direction DR3, and a normal line direction of each of the front and rear surfaces may be substantially parallel to the third direction DR3. A separation distance between the front surface and the rear surface in the third direction DR3 may correspond to a thickness in the third direction DR3 of each member.

In the disclosure, the expression "in a plan view" may mean a state of being viewed in the third direction DR3. In the disclosure, the expression "in a cross-section" may mean a state of being viewed in the first direction DR1 or the second direction DR2. Directions indicated by the first, second, and third directions DR1, DR2, and DR3 are relative to each other, and thus, the directions indicated by the first, second, and third directions DR1, DR2, and DR3 may be changed to other directions.

The electronic device ELD may display an image IM to the third direction DR3 through a display surface IS substantially parallel to the plane defined by the first direction DR1 and the second direction DR2. However, the shape of the display surface IS should not be limited thereto or thereby, and the display surface IS may further include a curved surface bent from at least one side of the plane. The display surface IS through which the image IM is displayed may correspond to a front surface of the electronic device ELD. The image IM may include a video as well as a still image. FIG. 1 shows a clock widget and application icons as representative embodiments of the image IM.

The electronic device ELD may have a quadrangular shape, e.g., rectangular shape with short sides extending in the first direction DR1 and long sides extending in the second direction DR2 intersecting the first direction DR1. However, the shape of the electronic device ELD should not be limited to the quadrangular shape, e.g., rectangular shape, and the electronic device ELD may have a variety of shapes, such as a circular shape, a polygonal shape, etc.

The electronic device ELD may sense an external input TC applied thereto from the outside. The external input TC may include inputs of various forms, such as force, pressure, temperature, light, etc. In the illustrated embodiment, a touch input generated by a hand of a user US and applied to the front surface of the electronic device ELD will be described as an illustrative embodiment of the external input TC. However, this is merely one of the embodiments, and the external input TC may include all types of inputs that cause a variation in capacitance. The area of the electronic device ELD in which the external input TC is sensed should not be limited to the front surface of the electronic device ELD, and the electronic device ELD may sense the external input TC by the user US applied to a side or rear surface of the electronic device ELD depending on a structure of the electronic device

### ELD.

The display surface IS of the electronic device ELD may include an image area IA and a bezel area BZA. The image IM may be displayed through the image area IA. The user may view the image IM through the image area IA. In the illustrated embodiment, the image area IA may have a quadrangular shape with rounded vertices. However, this is merely one of the embodiments, and the image area IA may have a variety of shapes.

The bezel area BZA may have a predetermined color and may block the light. The bezel area BZA may be defined next to (or adjacent to) the image area IA. In an embodiment, the bezel area BZA may be disposed outside the image area IA and may surround the image area IA. Accordingly, the shape of the image area IA may be substantially defined by the bezel area BZA, however, this is merely one of the embodiments. That is, the bezel area BZA may be disposed next to (or adjacent to) only one side of the image area IA, may be disposed at a side surface of the electronic device ELD, or may be omitted.

Referring to FIGS. 1 and 2, the electronic device ELD may include a window WM, a display device DD, an optical member AF, an electronic module EM, a power module PSM, and a case EDC.

The window WM may be disposed on the display device DD and the optical member AF. The window WM may protect the display device DD from external impacts and scratches applied to the display device DD. A front surface of the window WM may correspond to the display surface IS of the electronic device ELD.

The optical member AF may be disposed on the display device DD. The optical member AF may decrease a reflectance of the display device DD with respect to an external light. In an embodiment, the optical member AF may include a polarizing film including a retarder and/or a polarizer, a plurality of reflective layers destructively interfering with reflected lights, or a plurality of color filters disposed to correspond to an arrangement and a light emission color of the pixels. Different from the structure of the electronic device ELD shown in FIG. 2, the electronic device ELD may not include the optical member AF.

The display device DD may generate the image IM that travels to the outside of the electronic device ELD and may sense the external input TC. The display device DD may include a display panel DP and an input sensor ISP.

The display panel DP may display the image IM in response to electrical signals. The display panel DP in an embodiment may be a light-emitting type display panel, however, it should not be particularly limited. In an embodiment, the display panel DP may be an organic light-emitting display panel, an inorganic light-emitting display panel, or a quantum dot light-emitting display panel, for example. Hereinafter, the organic light-emitting display panel will be described as an illustrative embodiment of the display panel

### DP.

The input sensor ISP may be disposed on the display panel DP. The input sensor ISP may sense the external input TC and may provide an input signal including information about the external input TC to allow the display panel DP to display the image IM corresponding to the external input TC. The input sensor ISP may be driven in various methods, such as a capacitive method, a resistive film method, an infrared ray method, a sonic method, or a pressure method, however, it should not be particularly limited. Different from the structure of the electronic device ELD shown in FIG. 2, the electronic device ELD may not include the input sensor ISP.

The display device DD may include an active area AA and a peripheral area NAA defined next to (or adjacent to) the active area AA. Light-emitting elements of the display panel DP or sensing electrodes of the input sensor ISP may be disposed in the active area AA, and the display device DD may be activated in response to electrical signals to display the image IM in the active area AA or may sense the external input TC in the active area AA. A driving circuit, a signal line, and a pad may be disposed in the peripheral area NAA to drive elements in the active area AA.

The active area AA may overlap the image area IA of the electronic device ELD, and the peripheral area NAA may overlap the bezel area BZA of the electronic device ELD. Components disposed in the peripheral area NAA may be prevented from being viewed from the outside by the bezel area BZA.

The display device DD may further include a main circuit board MCB, a flexible circuit film FCB, a data driver DIC, a sensor control circuit T-IC, and a main controller 100.

The main circuit board MCB may include a plurality of driving elements. The main circuit board MCB may be electrically connected to the display panel DP and the input sensor ISP via the flexible circuit film FCB. The main circuit board MCB may be electrically connected to the electronic module EM via a connector.

The flexible circuit film FCB may be connected to the display panel DP to electrically connect the display panel DP to the main circuit board MCB. The input sensor ISP may be electrically connected to the display panel DP and may be electrically connected to the main circuit board MCB via the flexible circuit film FCB, however, the disclosure should not be limited thereto or thereby. In an embodiment, the input sensor ISP may be electrically connected to the main circuit board MCB via an additional flexible circuit film, or the flexible circuit film FCB may be omitted and the main circuit board MCB may be directly connected to the display panel DP.

Each of the data driver DIC, the sensor control circuit T-IC, and the main controller 100 may be provided in an integrated chip. The data driver DIC may be disposed (e.g., mounted) on the display panel DP, and the sensor control circuit T-IC and the main controller 100 may be disposed (e.g., mounted) on the main circuit board MCB, however, the disclosure should not be limited thereto or thereby. In an embodiment, the data driver DIC may be disposed (e.g., mounted) on the flexible circuit film FCB.

The main controller 100 may control an overall operation of the electronic device ELD. In an embodiment, the main controller 100 may control an operation of the display panel DP and the input sensor ISP. In addition, the main controller 100 may control an operation of the electronic module EM, for example. The main controller 100 may include at least one microprocessor.

The data driver DIC may include a driving circuit to drive pixels of the display panel DP. The data driver DIC may receive image data and control signals from the main controller 100. In an embodiment, the control signals may include an input vertical synchronization signal, an input horizontal synchronization signal, a main clock, and a data enable signals

The sensor control circuit T-IC may provide electrical signals to the input sensor ISP to drive the input sensor ISP. The sensor control circuit T-IC may receive a control signal such as a clock signal from the main controller 100.

The electronic module EM may include a variety of functional modules to drive the display device DD. In an embodiment, the electronic module EM may include a wireless communication module, an image input module, an audio input module, an audio output module, a memory, an external interface module, or the like. The modules of the electronic module EM may be disposed (e.g., mounted) on the main circuit board MCB or may be electrically connected to the main circuit board MCB via a separate flexible circuit board.

The power module PSM may be electrically connected to the electronic module EM. The power module PSM may supply a power desired for an overall operation of the electronic device ELD. In an embodiment, the power module PSM may include a conventional battery.

The case EDC may be coupled with the window WM to define an exterior of the electronic device ELD. The window WM may be coupled with the case EDC to form an inner space to accommodate components of the electronic device ELD. The display device DD, the flexible circuit film FCB, the main circuit board MCB, the electronic module EM, and the power module PSM may be accommodated in the inner space. The display panel DP may be bent to allow the flexible circuit film FCB and the main circuit board MCB to face a rear surface of the display device DD and then may be accommodated in the case EDC.

The case EDC may include a material with a relatively high rigidity. In an embodiment, the case EDC may include a frame and/or a plate including or consisting of glass, plastic, metal material, or combinations thereof. The case EDC may absorb external impacts applied thereto from the outside and may prevent a foreign substance or moisture from entering therein to protect the display device DD.

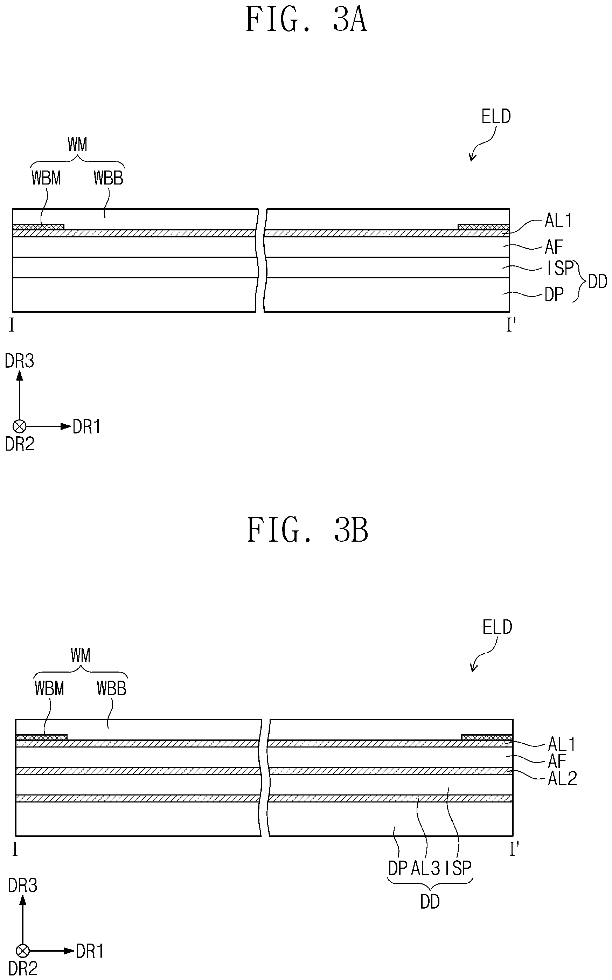

FIGS. 3A and 3B are cross-sectional views of electronic devices ELD taken along line I-I' of FIG. 2.

FIGS. 3A and 3B show various embodiments according to a stack structure of components included in the electronic device ELD, and details of the window WM, the display panel DP, and the input sensor ISP described with reference to FIGS. 1 and 2 may be applied to those of FIGS. 3A and 3B.

Referring to FIGS. 3A and 3B, the window WM may include a base film WBB and a bezel pattern WBM. The base film WBB may include an optically transparent insulating material. The base film WBB may include at least one of a glass film and a synthetic resin film. The base film WBB may have a single-layer structure or a multi-layer structure of two or more films attached to each other. The window WM may further include functional layers, such as an anti-fingerprint layer, a phase control layer, a hard coating layer, etc., disposed on the base film WBB.

The bezel pattern WBM may be a colored layer formed on a surface of the base film WBB. The bezel pattern WBM may include a material with a predetermined color. In an embodiment, the bezel pattern WBM may include a colored organic layer. The bezel pattern WBM may have a single-layer or multi-layer structure. The bezel pattern WBM having the multi-layer structure may include a chromatic color layer and a light-blocking layer having an achromatic color, e.g., a black color. The bezel pattern WBM may be formed through a depositing, printing, or coating process.

The bezel pattern WBM may be disposed to correspond to the bezel area BZA (refer to FIG. 1) of the electronic device ELD. An area of the window WM in which the bezel pattern WBM is disposed may have a light transmittance lower than that of an area in which the bezel pattern WBM is not disposed.

A first adhesive layer AL1 may be disposed between the window WM and the optical member AF. The window WM may be coupled with the optical member AF by the first adhesive layer AL1, however, the disclosure should not be limited thereto or thereby. In an embodiment, the first adhesive layer AL1 may be omitted, and the window WM may be disposed directly on the optical member AF.

Referring to FIG. 3A, the input sensor ISP may be disposed directly on the display panel DP. The input sensor ISP may be formed on a base surface provided by the display panel DP through successive processes in a manufacturing process of the display device DD. The input sensor ISP may be coupled integrally with the display panel DP without a separate adhesive.

Referring to FIG. 3A, the optical member AF may be disposed directly on the display device DD. In an embodiment, the optical member AF may be formed on an upper surface of the input sensor ISP through successive processes. The optical member AF may include a color filter, and the optical member AF may be formed by coating, patterning, or printing a composition for the color filter on a base surface provided by the input sensor ISP.

However, the disclosure should not be limited thereto or thereby, and referring to FIG. 3B, the optical member AF may be coupled with the display device DD by a second adhesive layer AL2. In an embodiment, the optical member AF may be provided in the form of a film, such as a polarizing film, and may be coupled with the display device DD by the second adhesive layer AL2 disposed on the upper surface of the input sensor ISP.

Referring to FIG. 3B, the display device DD may further include a third adhesive layer AL3 disposed between the input sensor ISP and the display panel DP. The input sensor ISP may be coupled with the display panel DP by the third adhesive layer AL3. In an embodiment, the input sensor ISP may be provided as a touch panel manufactured by a separate process different from the manufacturing process of the display panel DP, and the input sensor ISP may be coupled with the display panel DP by the third adhesive layer AL3 disposed on the upper surface of the display panel DP.

Each of the first, second, and third adhesive layers AL1, AL2, and AL3 may include a transparent adhesive, such as an optically clear adhesive ("OCA") film, an optically clear resin ("OCR"), or a pressure sensitive adhesive ("PSA") film, however, the adhesive included in the first, second, and third adhesive layers AL1, AL2, and AL3 should not be limited thereto or thereby.

The stack structure and the stack order of components included in the electronic devices ELD shown in FIGS. 3A and 3B are merely illustrative embodiments, and the disclosure should not be limited thereto or thereby. In an embodiment, the electronic device ELD may further include a protective layer disposed under the display panel DP or the optical member AF may be omitted. In addition, the stack order of the optical member AF and the input sensor ISP may be changed, and the optical member AF may be disposed between the display panel DP and the input sensor ISP.

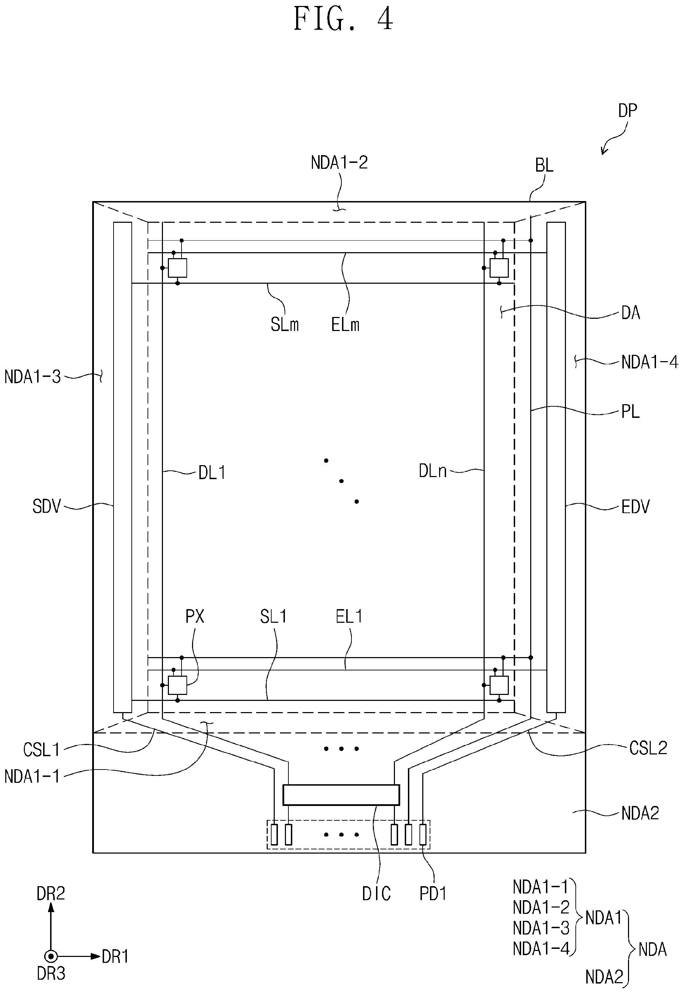

FIG. 4 is a plan view of an embodiment of the display panel DP according to the disclosure.

Referring to FIG. 4, the display panel DP may include a base layer BL, a plurality of pixels PX, a plurality of signal lines SL1 to SLm, DL1 to DLn, EL1 to ELm, CSL1, CSL2, and PL electrically connected to the pixels PX, a scan driver SDV, the data driver DIC, an emission driver EDV, and a plurality of pads PD1.

The base layer BL may provide a base surface on which elements and lines of the display panel DP are disposed. The base layer BL may include a display area DA and a non-display area NDA. The display area DA may be an area in which the pixels PX are disposed to display the image, and the non-display area NDA may be an area in which elements and lines are disposed to drive the pixels PX and the image is not displayed and may be disposed next to (or adjacent to) the display area DA. The display area DA may correspond to the active area AA (refer to FIG. 2) of the display device DD, and the non-display area NDA may correspond to the peripheral area NAA (refer to FIG. 2) of the display device DD.

The display panel DP includes the display area DA and the non-display area NDA defined therein. The non-display area NDA may be defined to surround the display area DA.

The non-display area NDA includes an edge area NDA1. In detail, the edge area NDA1 includes a first edge area NDA1-1 extending in the first direction DR1, a second edge area NDA1-2 spaced apart from the first edge area NDA1-1 in the second direction DR2 and extending in the first direction DR1, a third edge area NDA1-3 extending in the second direction DR2 and connecting one end of the first edge area NDA1-1 and one end of the second edge area NDA1-2, and a fourth edge area NDA1-4 spaced apart from the third edge area NDA1-3 in the first direction DR1 and extending in the second direction DR2. The fourth edge area NDA1-4 may connect an opposite end of the first edge area NDA1-1 and an opposite end of the second edge area NDA1-2.

The non-display area NDA may further include a pad area NDA2 spaced apart from the display area DA and next to (or adjacent to) the edge area NDA1. In detail, the pad area NDA2 may be disposed next to (or adjacent to) the first edge area NDA1-1. The pads PD1 may be disposed in the pad area NDA2.

Each of the pixels PX may include a pixel driving circuit including a plurality of transistors, e.g., a switching transistor, a driving transistor, etc., and a capacitor and a light-emitting element electrically connected to the pixel driving circuit. Each of the pixels PX may emit a light in response to electrical signals applied thereto.

Each of the scan driver SDV, the data driver DIC, and the emission driver EDV may be disposed in the non-display area NDA, however, the disclosure should not be limited thereto or thereby. In an embodiment, at least one of the scan driver SDV, the data driver DIC, and the emission driver EDV may be disposed in the display area DA, and thus, a size of the non-display area NDA may be reduced.

The signal lines SL1 to SLm, DL1 to DLn, EL1 to ELm, CSL1, CSL2, and PL may include a plurality of scan lines SL1 to SLm, a plurality of data lines DL1 to DLn, a plurality of emission lines EL1 to ELm, a first control line CSL1, a second control line CSL2, and a power line PL. Each of m and n is a natural number. Each of the pixels PX may be electrically connected to a corresponding scan line among the scan lines SL1 to SLm, a corresponding data line among the data lines DL1 to DLn, and a corresponding emission line among the emission lines EL1 to ELm. More types of signal lines may be provided in the display panel DP depending on the configuration of the pixel driving circuit of the pixels PX.

The scan lines SL1 to SLm may extend in a direction opposite to the first direction DR1 and may be electrically connected to the scan driver SDV. The data lines DL1 to DLn may extend in a direction opposite to the second direction DR2 and may be electrically connected to the data driver DIC. The emission lines EL1 to ELm may extend in the first direction DR1 and may be electrically connected to the emission driver EDV.

The power line PL may include a portion extending in the first direction DR1 and a portion extending in the second direction DR2. The portion of the power line PL extending in the first direction DR1 and the portion of the power line PL extending in the second direction DR2 may be disposed in different layers from each other and may be connected to each other via a contact hole, however, they should not be limited thereto or thereby. In an embodiment, the portion of the power line PL extending in the first direction DR1 and the portion of the power line PL extending in the second direction DR2 may be disposed in the same layer and may be provided integrally with each other.

The portion of the power line PL extending in the first direction DR1 may extend to the display area DA and may be electrically connected to the pixels PX, and the portion of the power line PL extending in the second direction DR2 may be disposed in the non-display area NDA and may extend to the pads PD1. The power line PL may receive a power supply voltage and may provide the power supply voltage to the pixels PX.

The first control line CSL1 may be electrically connected to the scan driver SDV. The second control line CSL2 may be electrically connected to the emission driver

### EDV.

The pads PD1 may be disposed next to (or adjacent to) a lower end of the non-display area NDA. The pads PD1 may be disposed closer to a lower end of the display panel DP than the data driver DIC is to the lower end of the display panel DP. The pads PD1 may be arranged spaced apart from each other in the first direction DR1. The pads PD1 may be electrically connected to a circuit board that provides a signal to control an operation of the scan driver SDV, the data driver DIC, and the emission driver EDV.

Each of the pads PD1 may be connected to a corresponding signal line among the signal lines SL1 to SLm, DL1 to DLn, EL1 to ELm, CSL1, CSL2, and PL. In an embodiment, the power line PL, the first and second control lines CSL1 and CSL2, and the data lines DL1 to DLn may be connected to corresponding pads PD1. The data lines DL1 to DLn may be connected to the corresponding pads PD1 via the data driver DIC.

The scan driver SDV may generate a plurality of scan signals in response to a scan control signal. The scan signals may be applied to the pixels PX via the scan lines SL1 to SLm. The data driver DIC may generate a plurality of data voltages corresponding to image signals in response to a data control signal. The data voltages may be applied to the pixels PX via the data lines DL1 to DLn. The emission driver EDV may generate a plurality of emission signals in response to an emission control signal. The emission signals may be applied to the pixels PX via the emission lines EL1 to ELm.

The pixels PX may receive the data voltages in response to the scan signals. The pixels PX may emit a light having a luminance corresponding to the data voltages in response to the emission signals, and thus, the image may be displayed. An emission time of the pixels PX may be controlled by the emission signals. Accordingly, the display panel DP may display the image through the display area DA using the pixels PX.

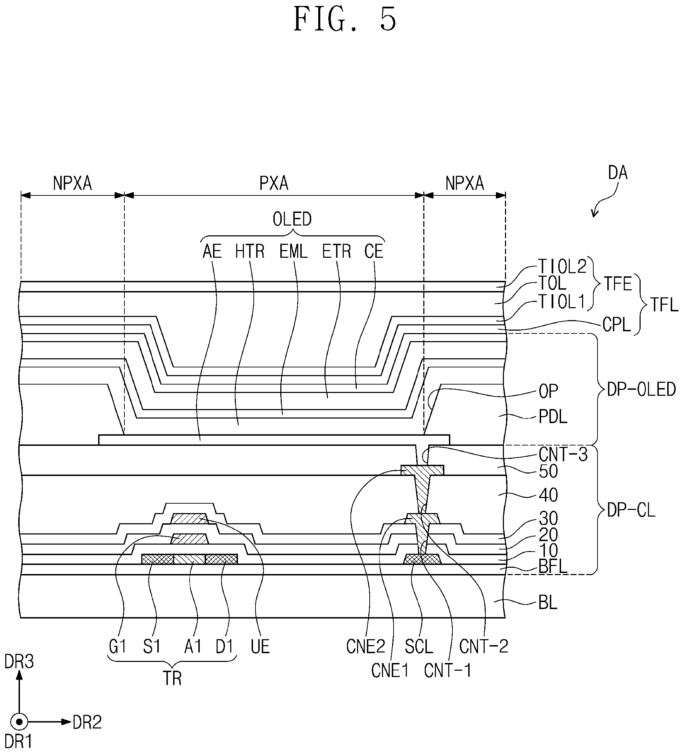

FIG. 5 is a cross-sectional view of an embodiment of a portion of the display area DA according to the disclosure.

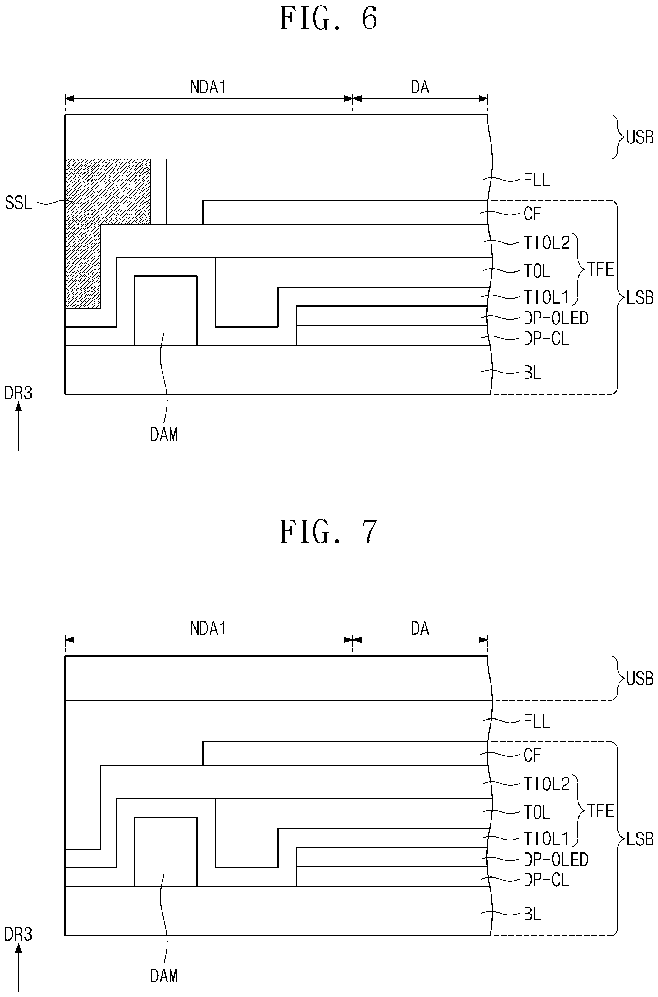

FIG. 5 shows some layers of a lower substrate LSB (refer to FIGS. 6 and 7) of the display panel DP. In detail, FIG. 5 shows the light-emitting element OLED and the transistor TR of the pixel PX (refer to FIG. 4) included in the display area DA of the display panel DP as an illustrative embodiment.

The display panel DP may include a base layer BL, a circuit layer DP-CL, a light-emitting element layer DP-OLED, and an upper insulating layer TFL. The circuit layer DP-CL, the light-emitting element layer DP-OLED, and the upper insulating layer TFL may be disposed on the base layer BL.

The base layer BL may provide a base surface on which the circuit layer DP-CL, the light-emitting element layer DP-OLED, and the upper insulating layer TFL are stacked. The base layer BL may be a rigid substrate or a flexible substrate that is bendable, foldable, or rollable. The base layer BL may be a glass substrate, a metal substrate, or a polymer substrate, however, it should not be limited thereto or thereby. In an embodiment, the base layer BL may include an inorganic layer, an organic layer, or a composite material layer.

The base layer BL may have a multi-layer structure. In an embodiment, the base layer BL may include a first synthetic resin layer, an inorganic layer having a single-layer or multi-layer structure, and a second synthetic resin layer disposed on the inorganic layer having the single-layer or multi-layer structure, for example. Each of the first and second synthetic resin layers may include a polyimide-based resin, however, it should not be particularly limited.

The circuit layer DP-CL may be disposed on the base layer BL. The circuit layer DP-CL may include a plurality of insulating layers, a plurality of conductive layers, and a semiconductor layer. The conductive layers of the circuit layer DP-CL may form signal lines or a control circuit of a pixel.

The light-emitting element layer DP-OLED may be disposed on the circuit layer DP-CL. The light-emitting element layer DP-OLED may include light-emitting elements. In an embodiment, the light-emitting element layer DP-OLED may include organic light-emitting elements, inorganic light-emitting elements, organic-inorganic light-emitting elements, micro-light emitting diodes ("micro-LEDs"), nano-LEDs, quantum light-emitting elements, electrophoretic light-emitting elements, electrowetting light-emitting elements, etc., for example.

The upper insulating layer TFL may include a capping layer CPL and a thin film encapsulation layer.

The upper insulating layer TFL may be disposed on the light-emitting element layer DP-OLED and may protect the light-emitting element layer DP-OLED from moisture, oxygen, and a foreign substance such as dust particles. The upper insulating layer TFL may encapsulate the light-emitting element layer DP-OLED to prevent moisture and oxygen from entering the light-emitting element layer DP-OLED.

The circuit layer DP-CL may include at least one insulating layer and a circuit element. The circuit element may include a signal line and a pixel driving circuit. The circuit layer DP-CL may be formed by a coating or depositing process to form an insulating layer, a semiconductor layer, and a conductive layer and a photolithography process to pattern the insulating layer, the semiconductor layer, and the conductive layer.

A buffer layer BFL may include at least one inorganic layer. A semiconductor pattern may be disposed on the buffer layer BFL. The buffer layer BFL may increase a coupling force between the base layer BL and the semiconductor pattern.

The semiconductor pattern may include polysilicon, however, it should not be limited thereto or thereby. The semiconductor pattern may include an amorphous silicon or metal oxide. FIG. 5 shows a portion of the semiconductor pattern, and the semiconductor pattern may be further disposed in other areas of the pixel in the plan view. The semiconductor pattern may be arranged with a predetermined rule over the pixels PX.

The semiconductor pattern may have different electrical properties depending on whether it is doped or not. The semiconductor pattern may include a first region A1 with relatively low doping concentration and relatively low conductivity and second regions S1 and D1 with relatively high doping concentration and relatively high conductivity. One second region S1 may be disposed at one side of the first region A1, and the other second region D1 may be disposed at an opposite side of the first region A1. The second regions S1 and D1 may be doped with an N-type dopant or a P-type dopant. A P-type transistor may include a doped region doped with the P-type dopant. The first region A1 may be a non-doped region or may be doped at a concentration lower than that of the second regions S1 and D1.

The second regions S1 and D1 may substantially serve as an electrode or a signal line. The one second region S1 may correspond to a source of the transistor TR, and the other second region D1 may correspond to a drain of the transistor TR. FIG. 5 shows a portion of a connection signal line SCL including or consisting of the semiconductor pattern. Although not shown in FIG. 5, the connection signal line SCL may be connected to the drain of the transistor TR in the plan view.

A first insulating layer 10 may be disposed on the buffer layer BFL. The first insulating layer 10 may commonly overlap the pixels arranged in the display area DA and may cover the semiconductor pattern. The first insulating layer 10 may be an inorganic layer and/or an organic layer and may have a single-layer or multi-layer structure. The first insulating layer 10 may include at least one of aluminium oxide, titanium oxide, silicon oxide, silicon oxynitride, zirconium oxide, and hafnium oxide. Not only the first insulating layer 10 but also an insulating layer of the circuit layer DP-CL described later may be an inorganic layer and/or an organic layer and may have a single-layer or multi-layer structure.

A gate G1 may be disposed on the first insulating layer 10. The gate G1 may be a portion of a metal pattern. The gate G1 may overlap the first region A1. The gate G1 may be used as a mask in a process of doping the semiconductor pattern.

A second insulating layer 20 may be disposed on the first insulating layer 10 and may cover the gate G1. The second insulating layer 20 may commonly overlap the pixels. An upper electrode UE may be disposed on the second insulating layer 20. The upper electrode UE may overlap the gate G1. The upper electrode UE may include a plurality of metal layers. In an embodiment, the upper electrode UE may be omitted.

A third insulating layer 30 may be disposed on the second insulating layer 20 and may cover the upper electrode UE. A first connection electrode CNE1 may be disposed on the third insulating layer 30. The first connection electrode CNE1 may be connected to the connection signal line SCL via a contact hole CNT-1 defined through the first, second, and third insulating layers 10, 20, and 30.

A fourth insulating layer 40 may be disposed on the third insulating layer 30, and a fifth insulating layer 50 may be disposed on the fourth insulating layer 40. The fourth insulating layer 40 may be an organic layer. A second connection electrode CNE2 may be disposed on the fourth insulating layer 40. The second connection electrode CNE2 may be connected to the first connection electrode CNE1 via a contact hole CNT-2 defined through the fourth insulating layer 40.

The fifth insulating layer 50 may be disposed on the fourth insulating layer 40 and may cover the second connection electrode CNE2. The fifth insulating layer 50 may be an organic layer.

The light-emitting element OLED may be disposed on the fifth insulating layer 50. A first electrode AE may be disposed on the fifth insulating layer 50. The first electrode AE may be connected to the second connection electrode CNE2 via a contact hole CNT-3 defined through the fifth insulating layer 50. A pixel definition layer PDL may be provided with a pixel opening OP defined therethrough. At least a portion of the first electrode AE may be exposed through the pixel opening OP of the pixel definition layer PDL. The pixel definition layer PDL may be an organic layer.

The display area DA may include a pixel area PXA and a non-pixel area NPXA next to (or adjacent to) the pixel area PXA. The non-pixel area NPXA may surround the pixel area PXA. In the illustrated embodiment, the pixel area PXA may be defined to correspond to the portion of the first electrode AE, which is exposed through the pixel opening OP.

The light-emitting element OLED may include the first electrode AE, a hole transport region HTR, a light-emitting layer EML, an electron transport region ETR, and a second electrode CE. The hole transport region HTR may be disposed on the first electrode AE. The light-emitting layer EML may be disposed on the hole transport region HTR. The second electrode CE may be disposed on the hole transport region HTR. The second electrode CE may have a single unitary shape.

The hole transport region HTR, the light-emitting layer EML, and the electron transport region ETR may be commonly formed over the pixels using an open mask, however, the disclosure should not be limited thereto or thereby. In an embodiment, at least one of the hole transport region HTR, the light-emitting layer EML, and the electron transport region ETR may be formed through a patterning process using a mask.

The upper insulating layer TFL may be disposed on the light-emitting element layer DP-OLED and may include a plurality of thin layers. In an embodiment, the upper insulating layer TFL may include a capping layer CPL and an encapsulation layer TFE disposed on the capping layer CPL. The capping layer CPL may be disposed on the second electrode CE and may contact the second electrode CE. The capping layer CPL may include an organic material.

The encapsulation layer TFE may include a first inorganic encapsulation layer TIOL1, an organic encapsulation layer TOL disposed on the first inorganic encapsulation layer TIOL1, and a second inorganic encapsulation layer TIOL2 disposed on the organic encapsulation layer TOL. The first inorganic encapsulation layer TIOL1 and the second inorganic encapsulation layer TIOL2 may protect the light-emitting element layer DP-OLED from moisture and oxygen, and the organic encapsulation layer TOL may protect the light-emitting element layer DP-OLED from a foreign substance such as dust particles.

FIGS. 6 to 7 are cross-sectional views of portions of display panels according to the disclosure.

FIGS. 6 and 7 show the edge area NDA1 described above and a portion of the display area DA next to (or adjacent to) the edge area NDA1 as an illustrative embodiment. The edge area NDA1 shown in FIGS. 6 and 7 may correspond to at least one of the first, second, third, and fourth edge areas NDA1-1, NDA1-2, NDA1-3, and NDA1-4 (refer to FIG. 4).

Referring to FIGS. 6 and 7, the display panel DP include the lower substrate LSB, an upper substrate USB disposed on the lower substrate LSB, and a filler FLL disposed between the lower substrate LSB and the upper substrate USB.

The lower substrate LSB may include the circuit layer DP-CL, the light-emitting element layer DP-OLED, and the upper insulating layer TFL. In addition, the lower substrate LSB may further include a color filter layer CF disposed on the upper insulating layer TFL. Although not shown in FIGS. 6 and 7, the lower substrate LSB may further include functional layers disposed above the upper insulating layer TFL to improve a light emission quality in addition to the color filter layer CF.

The upper substrate USB may be also referred to as an encapsulation substrate. The upper substrate USB may include a plastic substrate, a glass substrate, a metal substrate, or an organic/inorganic composite material substrate. The upper substrate USB may be spaced apart from the lower substrate LSB with a predetermined gap.

The filler FLL is disposed to overlap at least the display area DA. The filler FLL is disposed between the upper substrate USB and the lower substrate LSB and may be filled between the upper substrate USB and the lower substrate LSB. The filler FLL may include a desiccant or resin material.

A seal SSL is disposed between the upper substrate USB and the lower substrate LSB and may combine the upper substrate USB with the lower substrate LSB. The seal SSL may include an organic adhesive or a frit.

A dam DAM may be disposed in the edge area NDA1. The dam DAM may include an insulating material. In the plan view, the dam DAM may be disposed to surround the display area DA.

Referring to FIG. 6, at least one of the first, second, third, and fourth edge areas NDA1-1, NDA1-2, NDA1-3, and NDA1-4 (refer to FIG. 4) includes the seal SSL disposed between the upper substrate USB and the lower substrate LSB. The seal SSL is disposed between the upper substrate USB and the lower substrate LSB and may combine the upper substrate USB with the lower substrate LSB. In the plan view, the seal SSL may be disposed to overlap the first inorganic encapsulation layer TIOL1 and the second inorganic encapsulation layer TIOL2 and may be disposed not to overlap the organic encapsulation layer TOL.

The filler FLL may extend from the display area DA and may be disposed to overlap a portion of the area in which the seal SSL is disposed. The filler FLL that extends from the display area DA may be spaced apart from the seal SSL in the plan view as shown in FIG. 6 or may be disposed to contact the seal SSL in the plan view.

Referring to FIG. 7, at least one of the first, second, third, and fourth edge areas NDA1-1, NDA1-2, NDA1-3, and NDA1-4 (refer to FIG. 4) may include the filler FLL between the upper substrate USB and the lower substrate LSB without including the seal SSL (refer to FIG 6). In this case, the filler FLL may extend from the display area DA and may be disposed in at least one of the first, second, third, and fourth edge areas NDA1-1, NDA1-2, NDA1-3, and NDA1-4. As shown in FIG. 7, the filler FLL that extends from the display area DA may be disposed entirely over at least one edge area in which the seal SSL is not disposed among the first, second, third, and fourth edge areas NDA1-1, NDA1-2, NDA1-3, and NDA1-4.

In an embodiment, the seal SSL may be disposed in one edge area of the first, second, third, and fourth edge areas NDA1-1, NDA1-2, NDA1-3, and NDA1-4, and the display panel may have the cross-section as shown in FIG. 6. In this case, the seal SSL may not be disposed in the other three edge areas (remaining three edge areas) among the first, second, third, and fourth edge areas NDA1-1, NDA1-2, NDA1-3, and NDA1-4, and the filler FLL may extend from the display area DA and may be disposed in the other three edge areas (remaining three edge areas). The display panel may have the cross-section as shown in FIG. 7.

In an embodiment, the seal SSL may be disposed in two edge areas among the first, second, third, and fourth edge areas NDA1-1, NDA1-2, NDA1-3, and NDA1-4, and the display panel may have the cross-section as shown in FIG. 6. In this case, the seal SSL may not be disposed in the other two edge areas (remaining two edge areas) among the first, second, third, and fourth edge areas NDA1-1, NDA1-2, NDA1-3, and NDA1-4, and the filler FLL may extend from the display area DA and may be disposed in the other two edge areas (remaining two edge areas). The display panel may have the cross-section as shown in FIG. 7.

In an embodiment, the seal SSL may be disposed in three edge areas among the first, second, third, and fourth edge areas NDA1-1, NDA1-2, NDA1-3, and NDA1-4 and may have the cross-section as shown in FIG. 6. In this case, the seal SSL may not be disposed in the other one edge area (remaining one edge area) among the first, second, third, and fourth edge areas NDA1-1, NDA1-2, NDA1-3, and NDA1-4, and the filler FLL may extend from the display area DA and may be disposed in the other one edge area (remaining one edge areas). The display panel may have the cross-section as shown in FIG. 7.

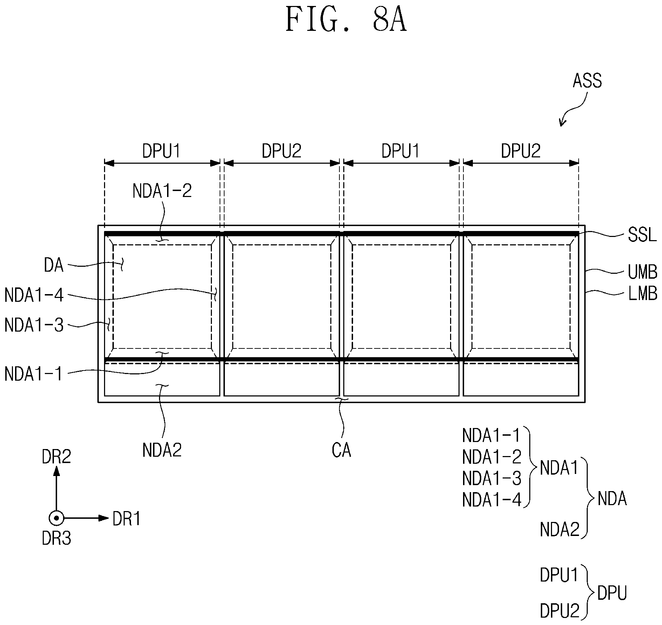

FIGS. 8A to 8E are plan views of an embodiment of a display panel assembly ASS according to the disclosure.

The seal SSL is disposed between an upper mother substrate UMB and a lower mother substrate LMB, however, in FIGS. 8A to 8E, the seal SSL is illustrated to show an arrangement relationship of the seal SSL between the upper mother substrate UMB and the lower mother substrate LMB in the plan view.

The display panel assembly ASS is to manufacture a plurality of unit display panels DPU. FIGS. 8A to 8E show the structure in which four unit display panels DPU are arranged in the display panel assembly ASS, however, the disclosure should not be limited thereto or thereby. By embodiments, two, three, five or more unit display panels DPU may be arranged in the display panel assembly ASS.

Referring to FIGS. 8A to 8E, the display panel assembly ASS may include the unit display panels DPU, and a cutting area CA surrounding the unit display panels DPU in the plan view may be defined in the display panel assembly ASS. The cutting area CA may be removed after being cut.

The display panel assembly ASS includes the upper mother substrate UMB, the lower mother substrate LMB, and the filler FLL (refer to FIGS. 6 and 7) disposed between the upper mother substrate UMB and the lower mother substrate LMB. The upper mother substrate UMB may overlap the lower mother substrate LMB in the plan view.

Descriptions on the upper substrate USB with reference to FIGS. 6 and 7 may be equally applied to the unit display panel DPU of the upper mother substrate UMB. Descriptions on the lower substrate LSB with reference to FIGS. 6 and 7 may be equally applied to the unit display panel DPU of the lower mother substrate LMB.

At least one edge area among the first, second, third, and fourth edge areas NDA1-1, NDA1-2, NDA1-3, and NDA1-4 includes the seal SSL disposed between the upper mother substrate UMB and the lower mother substrate LMB. The seal SSL may be directly disposed between the upper mother substrate UMB and the lower mother substrate LMB and may combine the upper mother substrate UMB with the lower mother substrate LMB.

The filler FLL extends from the display area DA of the unit display panel DPU and may be disposed to overlap the portion of the area in which the seal SSL is disposed. The filler FLL that extends from the display area DA may be spaced apart from the seal SSL in the plan view as shown in FIG. 6 or may be disposed to contact the seal SSL in the plan view.

At least one edge area among the first, second, third, and fourth edge areas NDA1-1, NDA1-2, NDA1-3, and NDA1-4 may include the filler FLL between the upper substrate USB and the lower substrate LSB without including the seal SSL. In this case, the filler FLL may extend from the display area DA and may be disposed in at least one of the first, second, third, and fourth edge areas NDA1-1, NDA1-2, NDA1-3, and NDA1-4. The filler FLL that extends from the display area DA may be disposed entirely over at least one edge area in which the seal SSL is not disposed among the first, second, third, and fourth edge areas NDA1-1, NDA1-2, NDA1-3, and NDA1-4 as shown in FIG. 7.

The unit display panels DPU may include a plurality of first unit display panels DPU1 and a plurality of second unit display panels DPU2 spaced apart from and alternately arranged with the first unit display panels DPU1 in the first direction DR1.

In an embodiment, the seal SSL may be disposed in two edge areas among the first, second, third, and fourth edge areas NDA1-1, NDA1-2, NDA1-3, and NDA1-4 defined in the first unit display panels DPU1, and the display panel may have the cross-section as shown in FIG. 6. In this case, the filler FLL that extends from the display area DA may be disposed in the other two edge areas (remaining two edge areas) where the seal SSL is not disposed among the first, second, third, and fourth edge areas NDA1-1, NDA1-2, NDA1-3, and NDA1-4 defined in the first unit display panels DPU1, and the display panel may have the cross-section as shown in FIG. 7.

In an embodiment, the seal SSL may be disposed in one edge area among the first, second, third, and fourth edge areas NDA1-1, NDA1-2, NDA1-3, and NDA1-4 defined in the second unit display panels DPU2, and the display panel may have the cross-section as shown in FIG. 6. In this case, the filler FLL that extends from the display area DA may be disposed in the other three edge areas (remaining three edge areas) where the seal SSL is not disposed among the first, second, third, and fourth edge areas NDA1-1, NDA1-2, NDA1-3, and NDA1-4 defined in the second unit display panels DPU2, and the display panel may have the cross-section as shown in FIG. 7.

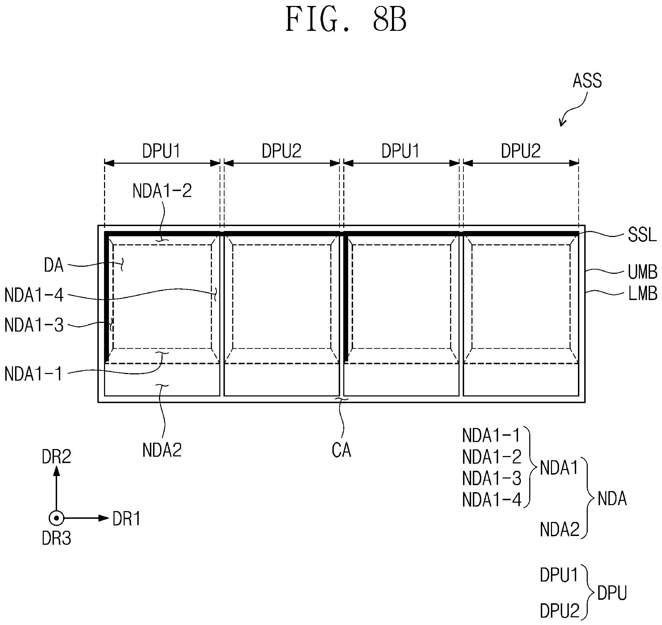

In detail, the seal SSL may be disposed in the second edge area NDA1-2 and the third edge area NDA1-3 of the first unit display panels DPU1 as shown in FIG. 8B. In the first unit display panels DPU1, the seal SSL may not be disposed in the first edge area NDA1-1 and the fourth edge area NDA1-4, and the filler FLL may extend to be disposed in the first edge area NDA1-1 and the fourth edge area NDA1-4. In the second unit display panels DPU2, the seal SSL may be disposed in the second edge area NDA1-2. In the second unit display panels DPU2, the seal SSL may not be disposed in the first edge area NDA1-1, the third edge area NDA1-3, and the fourth edge area NDA1-4, and the filler FLL may extend to be disposed in the first edge area NDA1-1, the third edge area NDA1-3, and the fourth edge area NDA1-4.

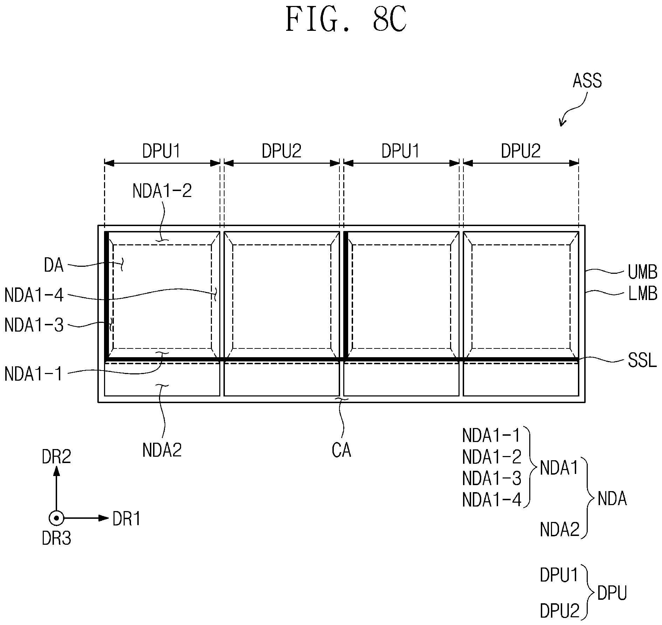

In an embodiment, in the first unit display panels DPU1, the seal SSL may be disposed in the first edge area NDA1-1 and the third edge area NDA1-3 as shown in FIG. 8C. In the first unit display panels DPU1, the seal SSL may not be disposed in the second edge area NDA1-2 and the fourth edge area NDA1-4, and the filler FLL may extend to be disposed in the second edge area NDA1-2 and the fourth edge area NDA1-4. In the second unit display panels DPU2, the seal SSL may be disposed in the first edge area NDA1-1. In the second unit display panels DPU2, the seal may not be disposed in the second edge area NDA1-2, the third edge area NDA1-3, and the fourth edge area NDA1-4, and the filler FLL may extend to be disposed in the second edge area NDA1-2, the third edge area NDA1-3, and the fourth edge area NDA1-4.

In an embodiment, the seal SSL may be disposed in two edge areas among the first, second, third, and fourth edge areas NDA1-1, NDA1-2, NDA1-3, and NDA1-4 defined in the second unit display panels DPU2, and the display panel may have the cross-section as shown in FIG. 6. In this case, the filler FLL that extends from the display area DA may be disposed in the other two edge areas (remaining two edge areas) where the seal SSL is not disposed among the first, second, third, and fourth edge areas NDA1-1, NDA1-2, NDA1-3, and NDA1-4 defined in the second unit display panels DPU2, and the display panel may have the cross-section as shown in FIG. 7.

In detail, in both the first unit display panels DPU1 and the second unit display panels DPU2, the seal SSL may be disposed in the first edge area NDA1-1 and the second edge area NDA1-2 as shown in FIG. 8A. In both the first unit display panels DPU1 and the second unit display panels DPU2, the seal SSL may not be disposed in the third edge area NDA1-3 and the fourth edge area NDA1-4 and the filler FLL may be disposed in the third edge area NDA1-3 and the fourth edge area NDA1-4.

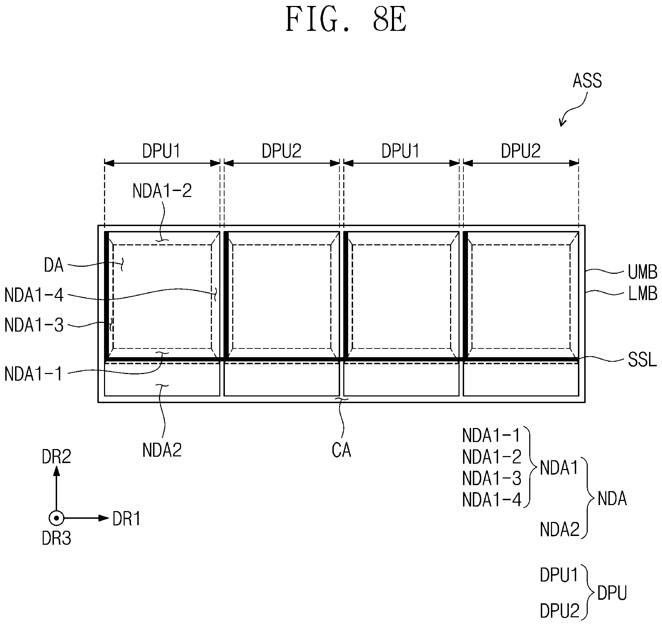

In an embodiment, in both the first unit display panels DPU1 and the second unit display panels DPU2, the seal SSL may be disposed in the first edge area NDA1-1 and the third edge area NDA1-3 as shown in FIG. 8E. In both the first unit display panels DPU1 and the second unit display panels DPU2, the seal SSL may not be disposed in the second edge area NDA1-2 and the fourth edge area NDA1-4 and the filler FLL may be disposed in the second edge area NDA1-2 and the fourth edge area NDA1-4.

In an embodiment, the seal SSL may be disposed in three edge areas among the first, second, third, and fourth edge areas NDA1-1, NDA1-2, NDA1-3, and NDA1-4 defined in the second unit display panels DPU2, and the display panel may have the cross-section as shown in FIG. 6. In this case, the filler FLL that extends from the display area DA may be disposed in the other one edge area (remaining one edge area) where the seal SSL is not disposed among the first, second, third, and fourth edge areas NDA1-1, NDA1-2, NDA1-3, and NDA1-4 defined in the second unit display panels DPU2, and the display panel may have the cross-section as shown in FIG. 7.

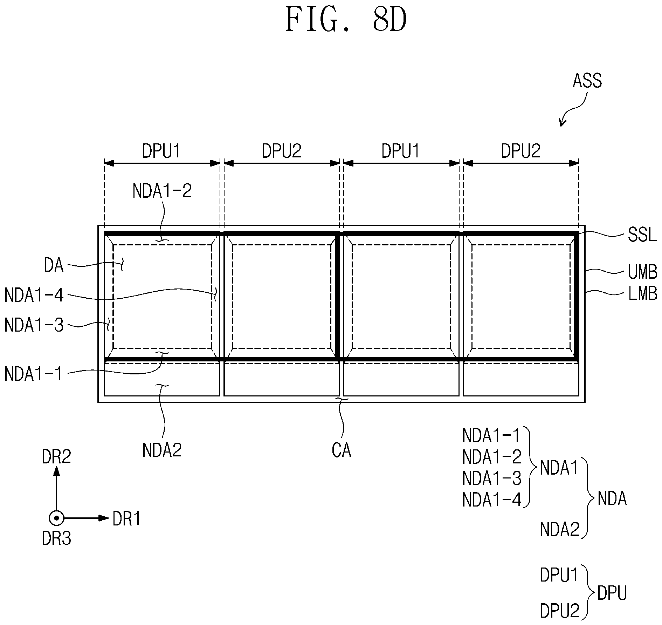

In detail, in the first unit display panels DPU1, the seal SSL may be disposed in the first edge area NDA1-1 and the second edge area NDA1-2 as shown in FIG. 8D. In the first unit display panels DPU1, the seal SSL may not be disposed in the third edge area NDA1-3 and the fourth edge area NDA1-4, and the filler FLL may extend to be disposed in the third edge area NDA1-3 and the fourth edge area NDA1-4. In the second unit display panels DPU2, the seal SSL may be disposed in the first edge area NDA1-1, the second edge area NDA1-2, and the fourth edge area NDA1-4. In the second unit display panels DPU2, the seal SSL may not be disposed in the third edge area NDA1-3, and the filler FLL may extend to be disposed in the third edge area NDA1-3.

As shown in FIGS. 8A to 8E, in the edge area NDA1 included in the unit display panel DPU, the seal SSL may be disposed in at least one edge area and may not be disposed in at least one edge area. According to the display panel assembly ASS having the above-described structure, processes to form the seal SSL may be simplified compared with a display panel assembly having a structure in which a seal is formed in all first to fourth edge areas NDA1-1 to NDA1-4. In addition, the unevenness or overlapping of the seal SSL may be reduced in areas where the first, second, third, and fourth edge areas NDA1-1, NDA1-2, NDA1-3, and NDA1-4 contact each other. Accordingly, the seal SSL may be prevented from being partially underfilled or overfilled, and the seal SSL may be prevented from bursting.

Although the embodiments of the disclosure have been described, it is understood that the disclosure should not be limited to these embodiments but various changes and modifications may be made by one ordinarily skilled in the art within the scope of the disclosure as hereinafter claimed. Therefore, the disclosed subject matter should not be limited to any single embodiment described herein, and the scope of the inventive concept shall be determined according to the attached claims.

## Claims

1. A display panel comprising:
a display area;
a non-display area comprising:
a first edge area extending in a first direction;
a second edge area spaced apart from the first edge area in a second direction perpendicular to the first direction and extending in the first direction;
a third edge area extending in the second direction and connecting an end of the first edge area and an end of the second edge area; and
a fourth edge area spaced apart from the third edge area in the first direction and extending in the second direction;
a lower substrate comprising a light-emitting element layer;
an upper substrate disposed on the lower substrate;
a filler disposed between the lower substrate and the upper substrate and overlapping the display area; and
a seal disposed between the upper substrate and the lower substrate in at least one edge area among the first to fourth edge areas,
wherein the filler extends from the display area and is disposed in at least one edge area among the first to fourth edge areas.

2. The display panel of claim 1, wherein the seal is directly disposed between the upper substrate and the lower substrate and combines the upper substrate and the lower substrate.

3. The display panel of claim 1 or claim 2, wherein the seal is disposed in one edge area among the first to fourth edge areas, and the filler extends and is disposed in the remaining three edge areas in which the seal is not disposed among the first to fourth edge areas.

4. The display panel of claim 1 or claim 2, wherein the seal is disposed in two edge areas among the first to fourth edge areas, and the filler extends and is disposed in the remaining two edge areas in which the seal is not disposed among the first to fourth edge areas.

5. The display panel of claim 1 or claim 2, wherein the seal is disposed in three edge areas among the first to fourth edge areas, and the filler extends and is disposed in the remaining one edge area in which the seal is not disposed among the first to fourth edge areas.

6. The display panel of any one of claims 1 to 5, wherein the non-display area further comprises a pad area spaced apart from the display area and next to the first edge area.

7. The display panel of any one of claims 1 to 6, wherein the lower substrate further comprises an encapsulation layer disposed on the light-emitting element layer, wherein the encapsulation layer comprises:
a first inorganic encapsulation layer disposed on the light-emitting element layer;
an organic encapsulation layer disposed on the first inorganic encapsulation layer; and
a second inorganic encapsulation layer disposed on the organic encapsulation layer, and
wherein the seal overlaps the first inorganic encapsulation layer and the second inorganic encapsulation layer and does not overlap the organic encapsulation layer.

8. A display panel assembly comprising: a plurality of unit display panels, each of the plurality of unit display panels comprising:
a display area;
a non-display area comprising:
a first edge area extending in a first direction;
a second edge area spaced apart from the first edge area in a second direction perpendicular to the first direction and extending in the first direction;
a third edge area extending in the second direction and connecting an end of the first edge area and an end of the second edge area; and
a fourth edge area spaced apart from the third edge area in the first direction and extending in the second direction;
a lower mother substrate comprising a light-emitting element;
an upper mother substrate disposed on the lower mother substrate; and
a filler disposed between the lower mother substrate and the upper mother substrate and overlapping the display area; and
a seal disposed between the upper mother substrate and the lower mother substrate in at least one edge area among the first to fourth edge areas,
wherein
the filler extends from the display area and is disposed in at least one edge area among the first to fourth edge areas.

9. The display panel assembly of claim 8, wherein a cutting area surrounding each of the plurality of unit display panels is defined in the display panel assembly.

10. The display panel assembly of claim 8 or claim 9, wherein the seal is directly disposed between the upper mother substrate and the lower mother substrate and combines the upper mother substrate and the lower mother substrate.

11. The display panel assembly of any one of claims 8 to 10, wherein the non-display area further comprises a pad area spaced apart from the display area and next to the first edge area.

12. The display panel assembly of any one of claims 8 to 11, wherein the plurality of unit display panels comprise a plurality of first unit display panels and a plurality of second unit display panels spaced apart from the plurality of first unit display panels and alternately arranged with the plurality of first unit display panels in the first direction,
wherein the seal is disposed in two edge areas among the first to fourth edge areas defined in the plurality of first unit display panels, and
the filler extends and is disposed in the remaining two edge areas in which the seal is not disposed among the first to fourth edge areas defined in the plurality of first unit display panels.

13. The display panel assembly of claim 12, wherein the seal is disposed in one edge area among the first to fourth edge areas defined in the plurality of second unit display panels, and
the filler extends and is disposed in the remaining three edge areas in which the seal is not disposed among the first to fourth edge areas defined in the plurality of second unit display panels.

14. The display panel assembly of claim 12, wherein the seal is disposed in two edge areas among the first to fourth edge areas defined in the plurality of second unit display panels, and
the filler extends and is disposed in the remaining two edge areas in which the seal is not disposed among the first to fourth edge areas defined in the plurality of second unit display panels.

15. The display panel assembly of claim 12, wherein the seal is disposed in three edge areas among the first to fourth edge areas defined in the plurality of second unit display panels, and
the filler extends and is disposed in the remaining one edge area in which the seal is not disposed among the first to fourth edge areas defined in the plurality of second unit display panels.
